# EUROPEAN PATENT SPECIFICATION

(11) **EP 1 685 417 B1**
(45) Date of publication and mention of the grant of the patent: **05.08.2009**
(21) Application number: 03768630.0
(22) Date of filing: 05.11.2003
(51) Int. Cl.: G01R 31/30, G01R 31/26

(54) **HOT SWITCHABLE VOLTAGE BUS FOR IDDQ CURRENT MEASUREMENTS**
HEISS UMSCHALTBARER SPANNUNGSBUS FÜR IDDQ-STROMMESSUNGEN
BUS DE TENSION COMMUTE A CHAUD PERMETTANT DE MESURER UN COURANT IDDQ

(43) Date of publication of application: 02.08.2006
(73) Proprietor: International Business Machines Corporation, Armonk, NY 10504 (US)
(72) Inventor: PASTEL, Leah, M., P., Essex Junction, VT 05452 (US)
(74) Representative: Williams, Julian David
(86) International application number: PCT/US2003/035116
(87) International publication number: WO 2005/047911

(56) References cited:
- EP-A- 0 856 794
- US-B1- 6 239 606
- US-B1- 6 664 801
- US-B2- 6 677 774
- LACKEY D E ET AL: "Managing power and performance for system-on-chip designs using voltage islands" IEEE/ACM INTERNATIONAL CONFERENCE ON COMPUTER AIDED DESIGN. ICCAD 2002. IEEE/ACM DIGEST OF TECHNICAL PAPERS. SAN JOSE, CA, NOV. 10 - 14, 2002, IEEE/ACM INTERNATIONAL CONFERENCE ON COMPUTER-AIDED DESIGN, NEW YORK, NY : IEEE, US, 10 November 2002 (2002-11-10), pages 195-202, XP010624646 ISBN: 0-7803-7607-2

## Description

The present invention relates in general to integrated circuits. More particularly, the present invention is directed to a voltage island system including a hot-switchable voltage bus for IDDQ current measurements.

Voltage islands are often designed into and implemented on integrated circuit chips to allow active and standby power reduction by changing the supply voltages to individual voltage islands. Voltage islands have also been implemented to reduce noise via supply isolation. The voltage island concept can reduce power consumption substantially by allowing designers to build, for example, processors that vary their voltages across a chip. For example, a single system-on-a-chip processor could be built to run one voltage in one or more areas of the chip, such as a processor core, a different voltage in other areas of the chip, and to switch off the voltage to areas of the chip that are not in use.

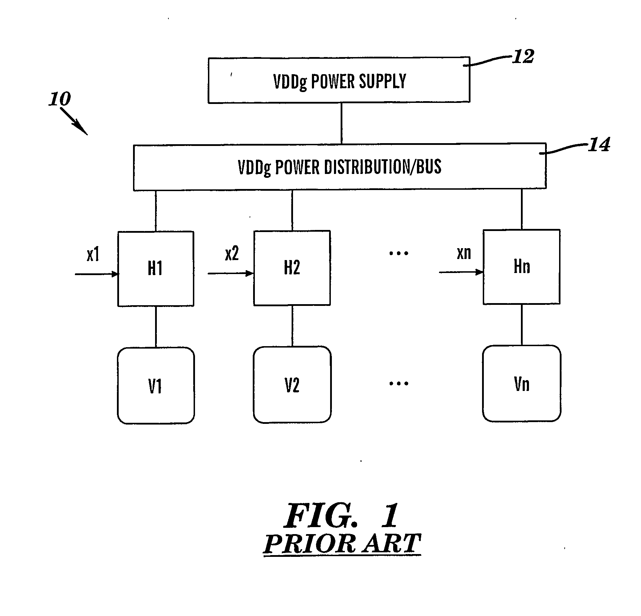

An example of a voltage island system 10 is illustrated in FIG. 1. As shown, the voltage island system 10 includes a plurality of voltage islands V1, V2, ..., Vn and a corresponding plurality of on-chip header devices H1, H2, .., Hn for selectively providing a voltage VDDg to the voltage islands V1, V2, ..., Vn in response to header control signals x1, x2, ..., xn, respectively. A global VDDg power supply 12 provides power to the header devices H1, H2, ..., Hn via a VDDg power distribution grid/bus 14.

A conventional integrated circuit employing voltage islands is described in Lackey D E et al: "Managing power and performance for system-on-chip designs using voltage islands" IEEE/ACM International Conference on Computer Aided Design" IEEE, US, 10 November 2002, pages 195-202, ISBN: 0-7803-7607-2.

In today's voltage island implementations, none, some, or all voltage islands of a chip can be powered up during test. One test, for example, involves measuring the quiescent current (IDDQ) in the VDD supply (e.g., VDDg power supply 12 in FIG. 1). This test is performed by measuring the current of a chip at the power supply (or ground) or chip terminals, typically after applying test patterns to the voltage islands via a scan chain. IDDQ testing depends on the fact that some defects in the chip cause additional quiescent current. By comparing the IDDQ value of the device under test (DUT) to a pass/fail value, a determination can be made as to whether the DUT is defective or not. The pass/fail value may be determined using statistics from individual wafers/lots, or may be determined using other known methods.

IDDQ testing has been shown to be effective in screening out a class of reliability problems. However, the effectiveness of IDDQ testing decreases as the level of subthreshold leakage or background current increases. For example, if the IDDQ test is capable of finding defects that cause a 10% increase in IDDQ, on a chip that typically measures 1mA during IDDQ test, a defect that generates 0.1 mA of additional current can be detected. On a chip that typically measures 1 A during IDDQ test, however, a defect must generate 100mA of current to be detected. Thus, on a chip that typically generates 1 A IDDQ, a defect that generates 0.1 mA of additional current will not be detected, and may result in a possibly unexposed reliability problem.

When IDDQ measurements are performed in the voltage island system 10 of FIG. 1 using the global VDDg power supply 12, some amount of background current is measured. If this level of background current could be reduced in some manner, smaller defects that produce smaller defect currents could be more easily detected. Accordingly, there exists a need for a method/apparatus for increasing the effectiveness of IDDQ testing by limiting the component of background current in the measurement. In addition, there exists a need for a method/apparatus for locating IDDQ defects in a voltage island system.

During IDDQ testing, voltage islands are often turned off/on in various configurations while applying the same test pattern. In the voltage island system 10 of FIG. 1, for example, the voltage islands V1, V2, ..., Vn may be tested using the same test pattern with all or none of the voltage islands turned on, with selected groups of the voltage islands turned on, or with single voltage islands turned on. Unfortunately, the same test pattern must be reapplied by the tester each time a different set of the voltage islands V1, V2, ..., Vn is tested, which uses test time inefficiently. This occurs because a voltage island loses state when it is turned off (i.e., not powered). Accordingly, there is a need for a method/apparatus for reducing the time required for IDDQ testing.

A preferred embodiment of the present invention provides a hot-switchable voltage bus for IDDQ current measurements. In accordance with the present invention, an integrated circuit (IC) can be broken up into voltage islands for IDDQ testing. A quiescent voltage bus (VDDq) is included in the IC. Voltage islands can be hot-switched between the IC power busses and VDDq to facilitate IDDQ testing.

A first aspect of the present invention is directed to a hot-switchable voltage bus for IDDQ measurement, characterised by the bus comprising: a global voltage bus; a quiescent voltage bus, separate from the global voltage bus; at least one voltage island (V1, V2, ..., Vn); a connection (H1, H2, ..., Hn; H1q, H2q, ..., Hnq) between each voltage island and the global and quiescent voltage busses; and a system for selecting at least one of the connections to connect each voltage island to at least one of the global and quiescent voltage busses during IDDQ testing.

A second aspect of the present invention is directed to a method for IDDQ testing, characterised by the method comprising: switching at least one voltage island (V1, V2, ..., Vn) between a global voltage bus and a quiescent voltage bus the switching comprising: providing a connection (H1, H2, ..., Hn; H1q, H2q, ..., Hnq) between each voltage island and the global and quiescent voltage busses, and selecting at least one of the connections to connect each voltage island to at least one of the global and quiescent voltage busses, and performing IDDQ testing on the at least one voltage island.

A third aspect of the present invention is directed to a method, comprising: hot-switching at least one voltage island between a plurality of different voltage busses, wherein each voltage island does not lose state during the hot-switching.

A fourth aspect of the present invention is directed to a method for monitoring power consumption, comprising: connecting at least one voltage island to a quiescent voltage bus; and monitoring power usage at a VDDq power supply connected to the quiescent voltage bus for the at least one voltage island.

The exemplary aspects of the present invention are designed to solve the problems herein described and other problems not discussed, which are discoverable by a skilled artisan.

Preferred embodiments of the present invention will now be described by way of example only with reference to the accompanying drawings, in which:
FIG. 1 illustrates a voltage island system in accordance with the prior art;
FIG. 2 illustrates an embodiment of a voltage island system including a hot-switchable voltage bus for IDDQ current measurements in accordance with the present invention;
FIGS. 3 and 4 illustrate an example of a hot-switching process that can be carried out in accordance with the present invention;
FIGS. 5 and 6 illustrate another example of a hot-switching process that can be carried out in accordance with the present invention;
FIG. 7 illustrates a voltage island system including a plurality of voltage sensors in accordance with the present invention; and,
FIG. 8a and 8b illustrate the location of an IDDQ defect using voltage sensors in accordance with the present invention.

It should be noted that the drawings are merely schematic representations, not intended to portray specific parameters of the invention. The drawings are intended to depict only typical aspects of the invention, and therefore should not be considered as limiting the scope of the invention. In the drawings, like numbering represents like elements.

A preferred embodiment of the present invention addresses the above-mentioned problems, as well as others, by providing a voltage island system including a hot-switch able voltage bus for IDDQ current measurements.

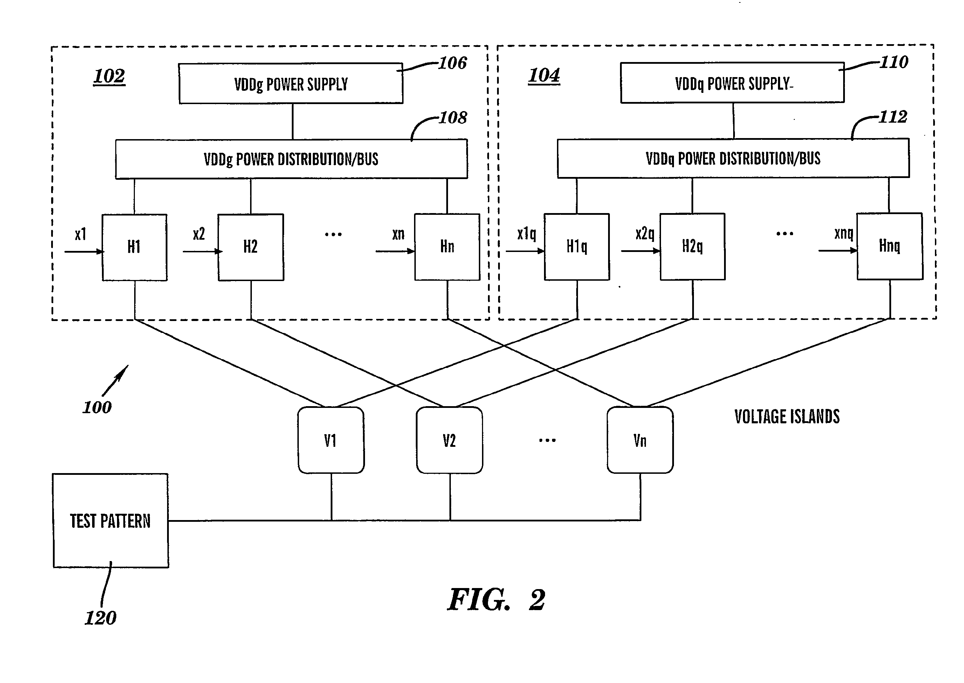

Referring now to FIG. 2, there is illustrated a voltage island system 100 in accordance with the present invention. As shown, the voltage island system 100 includes a plurality of voltage islands V1, V2, ..., Vn, a global power system 102, and a quiescent power system 104. The global power system 102 includes a first plurality of on-chip header devices H1, H2, ..., Hn for selectively providing a voltage VDDg to the plurality of voltage islands V1, V2, ..., Vn in response to first header control signals x1, x2, ..., xn, respectively. A global VDDg power supply 106 provides power to the header devices H1, H2, ..., Hn via a VDDg power distribution grid/bus 108. The quiescent power system 104 includes a second plurality of on-chip header devices H1q, H2q, ..., Hnq for selectively providing a quiescent voltage VDDq to the plurality of voltage islands V1, V2, ..., Vn in response to second header control signals x1q, x2q, ..., xnq, respectively. A quiescent VDDq power supply 110 provides power to the header devices H1q, H2q, ..., Hnq via a VDDq power distribution grid/bus 112. As detailed below, the incorporation of the quiescent power system 104 into the voltage island system 100 allows different circuitry (e.g., voltage islands V1, V2, ..., Vn) to be selectively and/or independently connected to either VDDq or VDDg during testing (e.g., IDDQ testing). Test pattern(s) 120 are provided to the plurality of voltage islands V1, V2, ..., Vn by a tester (not shown) during testing.

As shown in FIG. 2, the plurality of voltage islands V1, V2, ..., Vn can be selectively connected to a plurality of independent power supplies (i.e., the global VDDg power supply 106 and the quiescent VDDq power supply 110 in this embodiment) using independently controlled connections. To this extent, power can be selectively routed via header control signals x1, x2, ..., xn or header control signals x1q, x2q, ..., xnq to none, some, or all of the plurality of voltage islands V1, V2, ..., Vn. Thus, in the embodiment of the present invention illustrated in FIG. 2, each of the plurality of voltage islands V1, V2, ..., Vn can be selectively powered by either the global VDDg power supply 106 or the quiescent VDDq power supply 110, both power supplies 106, 110, or neither power supply 106, 110. The VDDg and VDDq power supplies output the same voltage (i.e., VDDg = VDDq) to the plurality of voltage islands V1, V2, ..., Vn .

In a preferred embodiment of the present invention, the quiescent VDDq power supply 110 and VDDq power distribution grid 112 are configured to provide a voltage VDDq and some small amount of current to the plurality of voltage islands V1, V2, ..., Vn when the quiescent VDDq power supply 110 is connected to the plurality of voltage islands V1, V2, ..., Vn. The quiescent VDDq power supply 110 and VDDq power distribution grid/bus 112 do not need to be as robust as the global VDDg power supply 106 and VDDg power distribution grid/bus 108. Accordingly, the quiescent VDDq power supply 110 and VDDq power distribution grid/bus 112 can take up less real estate on the integrated circuit chip on which the voltage island system 100 is formed. In addition, the quiescent VDDq power supply 110 and VDDq power distribution grid/bus 112 can have a greater resistance than the global VDDg power supply 106 and VDDg power distribution grid/bus 108. Advantageously, this greater resistance of can be used, as detailed below, to locate IDDQ defects within the voltage island system 100.

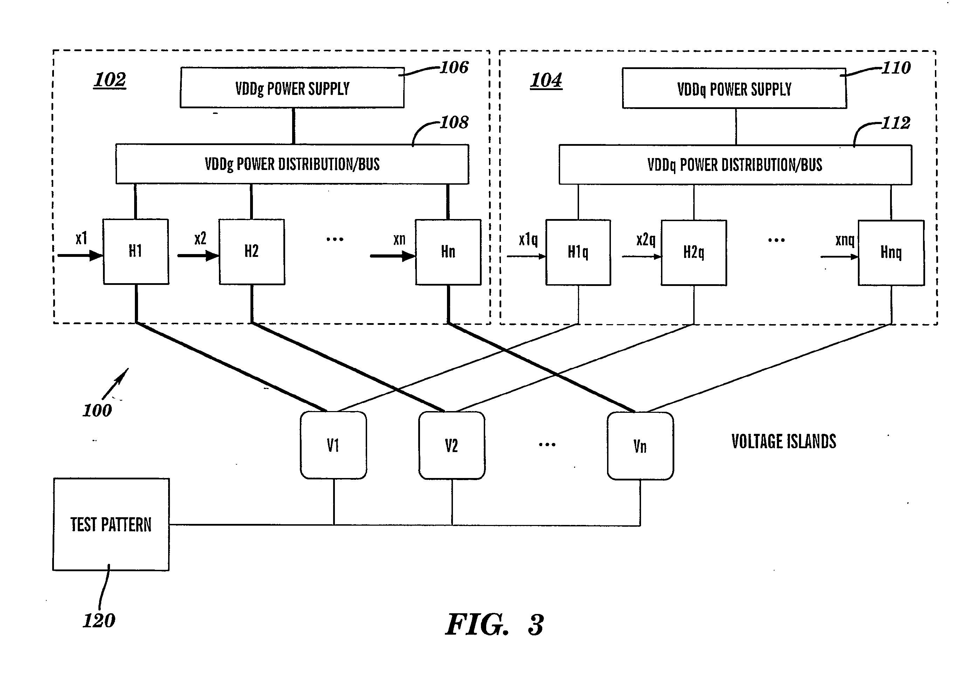

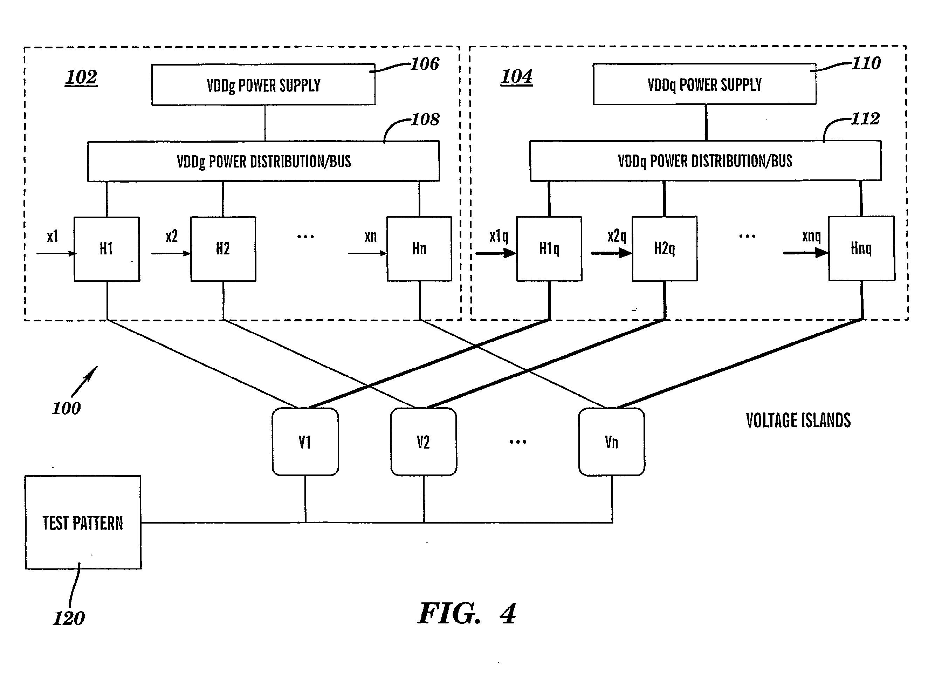

The plurality of voltage islands V1, V2, ..., Vn can be hot-switched between the global VDDg power supply 106 and the quiescent VDDq power supply 110 to selectively apply a voltage of either VDDg or VDDq (VDDq = VDDg) to each of the plurality of voltage islands V1, V2, ..., Vn. This is illustrated in FIG. 3, where the plurality of voltage islands V1, V2, ..., Vn are powered (indicated by thick lines) by the global VDDg power supply 106 (the quiescent VDDq power supply 110 is disconnected), and in FIG. 4, where the plurality of voltage islands V1, V2, ..., Vn are powered (indicated by thick lines) by the quiescent VDDg power supply 110 (the global VDDg power supply 106 is disconnected). Thus, the plurality of voltage islands V1, V2, ..., Vn always remain powered to substantially the same voltage level by either the global VDDg power supply 106 or the quiescent VDDq power supply 110 and, accordingly, none of the plurality of voltage islands loses state. As such, a test pattern 120 can be applied a single time to the plurality of voltage islands V1, V2, ..., Vn, and different sets of the plurality of voltage islands V1, V2, ..., Vn can be tested (e.g., IDDq testing) when powered by VDDg or VDDq (the test pattern 120 does not have to be reapplied (i.e., the test pattern remains valid) as would be required in the voltage island system 10 of the prior art).

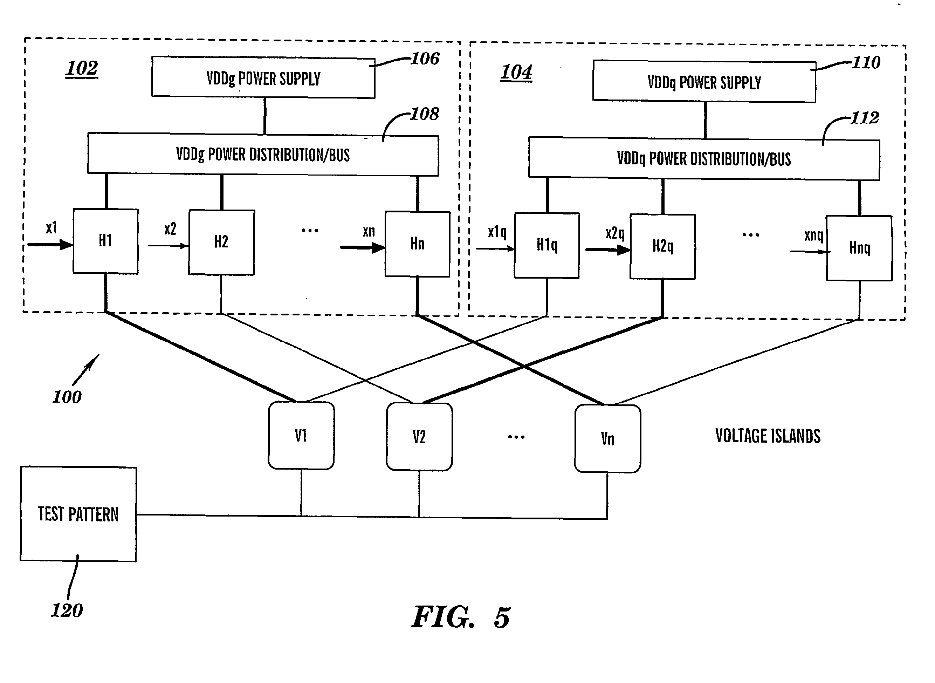

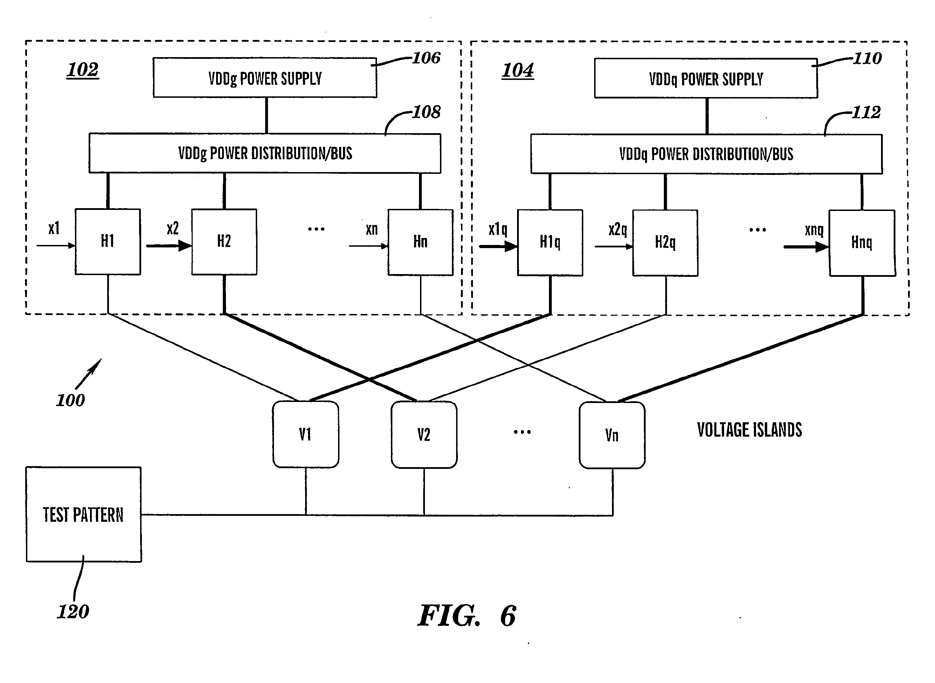

It should be noted that, in some cases, both the global VDDg power supply 106 and the quiescent VDDq power supply 110 can be turned on at the same time to selectively supply a voltage of either VDDg or VDDq (VDDq = VDDg) to each of the plurality of voltage islands V1, V2, ..., Vn in dependence of the activation/deactivation of the header devices H1, H2, ..., Hn and H1q, H2q, ..., Hnq. This is illustrated in FIGS. 5 and 6. In this example, the hot-switching is controlled by the header devices H1, H2, ..., Hn and H1q, H2q, ..., Hnq (assuming that the global VDDg power supply 106 and the quiescent VDDq power supply 110 are both on). In particular, as shown by the thick lines in FIG. 5, header device H1 is activated by control signal x1 to supply a voltage VDDg to voltage island V1, header device Hn is activated by control signal xn to supply a voltage VDDg to voltage island Vn, and header device H2q is activated by control signal x2q to supply a voltage VDDq to voltage island V2. The remaining voltage islands (not shown) are similarly provided with a voltage of VDDg or VDDq.

In FIG. 6, the voltage applied to each of the plurality of voltage islands V1, V2, ..., Vn, has been hot-switched from VDDg to VDDq, or from VDDq to VDDg. In particular, as shown by the thick lines in FIG. 6, header device H2 is activated by control signal x2 to supply a voltage VDDg to voltage island V2, header device H1q is activated by control signal x1q to supply a voltage VDDq to voltage island V1, and header device Hnq is activated by control signal xnq to supply a voltage VDDq to voltage island Vn. The remaining voltage islands (not shown) are similarly provided with a voltage of VDDg or VDDq. In each case, the plurality of voltage islands V1, V2, ..., Vn always remain powered up to the same voltage (VDDq = VDDg) and retain state.

In FIG. 5, a test pattern 120 can be applied to the plurality of voltage islands V1, V2, ..., Vn, while IDDQ testing is performed only on a subset of the voltage islands. For example, let us assume that IDDQ testing is performed only on voltage islands V1 and Vn in FIG. 5, which are powered by VDDg. Instead of turning the remaining voltage islands (i.e., V2, V3, ...Vn-1) off, as would be the case in the voltage island system 10 shown in FIG. 1, resulting in the remaining voltage islands losing state, these voltage islands are instead selectively connected to VDDq. Continuing this example with reference to FIG. 6, let us assume that IDDQ testing is subsequently performed only on voltage islands V2, V3, ...Vn-1, which are now powered by VDDg instead of VDDq (i.e., hot-switching has occurred). Since the voltage islands V2, V3, ...Vn did not lose state during the hot-switching process, the test pattern 120 does not have to be reapplied, as would be the case in the voltage island system 10 illustrated in FIG. 1, thus improving the time efficiency of the IDDQ testing.

Hot-switching between the global VDDg power supply 106 and the quiescent VDDq power supply 110, and/or between the voltages VDDg and VDDq, provides several advantages. For example, since the plurality of voltage islands V1, V2, ..., Vn are not powered down during the hot-switching process (i.e., the plurality of voltage islands V1, V2, ..., Vn will either be powered by VDDg or VDDq at all times), many IDDQ-type measurements can be made with the same test pattern and chip conditioning, providing more test flexibility and ensuring consistency between measurements. This is in contrast to the voltage island system 10 of FIG. 1, wherein the same test pattern must be reapplied by the tester each time and a different set of the voltage islands V1, V2, ..., Vn is tested. The reapplication of the test pattern is necessary in the prior art voltage island system 10 because the state of a voltage island, when disconnected from a power supply, decays with some RC time constant. In contrast, in accordance with the present invention, the plurality of voltage islands V1, V2, ..., Vn always remain powered, either by a voltage VDDg or VDDq (or both in some cases). It should be noted that hot switching in the present invention is performed at a speed sufficient to prevent the state of any voltage island from decaying to a point where the voltage island loses state.

Although shown as comprising two power supplies, i.e., the global VDDg power supply 106 and the quiescent VDDq power supply 110, it should be clear that the voltage island system 100 may include more than two power supplies coupled to the plurality of voltage islands V1, V2, ..., Vn. In addition, the selective application of voltage to the plurality of voltage islands V1, V2, ..., Vn can be provided using means other than header devices. It should also be noted that VDDq could be designed so that it is separate during IDDQ testing and becomes part of functional power for other testing and functional operations.

A voltage island system 100 embodying the present invention provides numerous advantages over the prior art. The advantages include, for example,: a) voltage island specific IDDQ measurements can be made by reconfiguring voltage island power connects (i.e., via header control signals x1, x2, ..., xn, x1q, x2q, ..., xnq) for IDDQ measurements; b) allows part disposition based on comparison of IDDQ measurements and calculated IDDQ, such as comparing the IDDQ for two instances of the same voltage island on a device; c) by reducing the amount of circuitry connected to power (or ground) during IDDQ measurement, the background leakage current is less, resulting in a higher IDDQ signal-to-noise ratio; d) IDDQ measurements can be used to detect and locate an IDDQ defect - resolution depends on granularity of voltage islands, background leakage current, and tester current measurement capability; e) routing between separate power supplies allows voltage islands to stay powered up and retain valid state; f) hot switching allows test pattern conditioning to be separated from voltage island connection configuration with appropriate logic included in the semiconductor device to allow voltage island connection changes independent of device conditioning; g) saves test pattern application time and complexity, ensures consistency between measurements, and facilitates search algorithms; h) global circuitry and voltage island circuitry can be separated, allowing direct measurements of IDDQ for voltage islands, and direct measurement of IDDQ for the global circuitry without disconnecting all the voltage islands from power; i) can collect IDDQ measurements from both the global voltage supply VDDg and the quiescent voltage supply VDDq at the same time (if have different external power supplies); j) because the quiescent power supply VDDq does not need to supply large amounts of current and only holds the voltage (DC supply) during IDDQ measurement, the quiescent power supply VDDq does not have to be as robust as the global power supply VDDg. Also, the VDDq power distribution grid/bus can be more resistive than the device operational power grids, as can the connection circuitry, although this does not have to be the case; k) allows current measurement with all voltage islands disconnected from the quiescent power supply VDDq; 1) the quiescent power supply VDDq can be combined with on-chip voltage sensors to monitor voltage at many locations inside the chip on the VDDq power distribution grid/bus, allowing many voltage measurements at once, and moving the measurements to the device, reducing acquisition time and required equipment needed to make current measurements; m) connections to the quiescent VDDq power supply need not be the same as those used for functional power management and, as such, they could be optimized for test; n) IDDQ can be measured for each different connection configuration between the plurality of voltage islands and the power supplies. This could provide an enhanced method of testing, depending on how the power supply connections are implemented. These IDDQ measurements could be compared with a threshold or compared against each other if appropriate for the design; o) the invention structure can be used with standard IDDQ testing (e.g., where the IDDQ value is compared against a threshold), delta IDDQ testing (where the distance between an IDDQ measurement and a previous IDDQ measurement is compared to a threshold, i.e., +/- 10%), and other more complex schemes, for example, where device IDDQ measurements are compared to sliding thresholds based on other standard measurements taken from the device, such as ring oscillator frequencies; p) the invention enables the use of another class of IDDQ test algorithms that use the IDDQ measurements from individual voltage islands or groups of islands to test the chip. For example, the IDDQ measurement for an individual voltage island or group of voltage islands could be compared with that of another instance of the same circuitry on the same chip, or IDDQ current measurements for each voltage island could be compared to the average measurement for all the voltage islands on a particular chip. In this way, variation amongst instances of the same circuitry could be measured, and individual measurements could be "normalized" for the background current of the device. These IDDQ measurements could also be used to compare between neighboring chips for statistical device dispositioning; q) on-chip voltage sensors could be used to test the device by locally thresholding, on-chip comparison of voltage levels, or downloading IDDQ measurements; and r) the voltage island system 100 can be used in an on-chip IDDQ BIST implementation.
A voltage island system 100 embodying the present invention enables use of automatic tester diagnostics to identify failing voltage island(s), using search schemes, such as binary search, to optimize search time, number of IDDQ measurements, power connection configurations, and number of test pattern iterations. Diagnostics and localization can be performed to varying degrees depending on the application. For example, IDDQ measurements for specific voltage island(s) can be cross-referenced to the physical location of the voltage island(s) and a map created. IDDQ maps provide a physical correlation to defect location (defect, source or sink), and can be used for yield analysis and to determine common fail signatures, as well as provide initial defect location estimates for hardware fault isolation techniques. The possible physical granularity of the IDDQ map depends on the granularity of the control logic and physical extent of each voltage island. Physical information in IDDQ maps can be used to differentiate between multiple defects on one chip by location and pattern (if more than one map). Further, on-chip voltage sensors may be used to provide pass/fail or voltage information. Voltage sensor locations can be cross-referenced to physical locations on the VDDq power distribution grid/bus and in the device, and a map created. Voltage maps can be used in the same applications as IDDQ maps. In addition, for finer diagnostics/localization, IDDQ measurements, results from test comparisons, and IDDQ current maps can be used to provide input to IDDQ software diagnostics. Voltage sensor measurements and VDDq conductance can also be used to locate an IDDQ defect. Measurements at multiple points on the VDDq power distribution grid/bus can improve detection and resolution of the IDDQ defects. Maps of VDDq conductance isobars can be used to triangulate the defect location.

The quiescent power system 104 of the present invention may also be used as a power monitor for power testing. This could be done at any level, for example, wafer test, packaged test, system test, and in the field. Basically, after a desired set of voltage islands are hot-switched onto the VDDq power distribution grid/bus 112 (i.e., connected to VDDq ), the device is tested/operated, and the VDDq power supply 110 current/ power (P=VI) is monitored. Power can be monitored when the device is in the quiescent state. During other testing and functional operation of the device, power can be monitored within the design constraints of the VDDq bus.

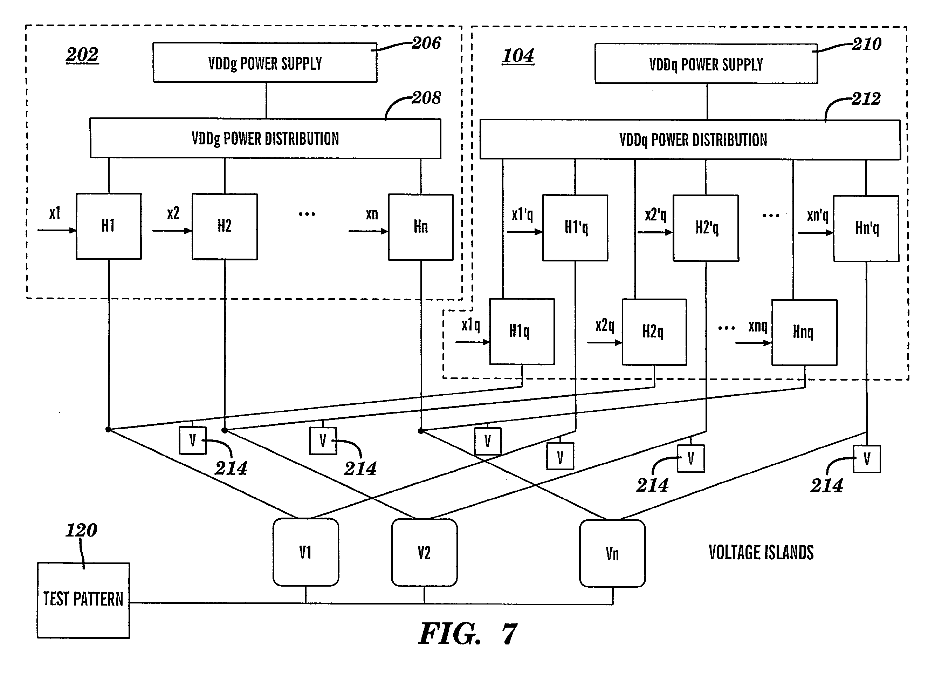

Another embodiment of a voltage island system 200 in accordance with the present invention is illustrated in FIG. 7. Similar to the voltage island system 100 shown in FIG. 2, the voltage island system 200 includes a plurality of voltage islands V1, V2, ..., Vn, a global power system 202, and a quiescent power system 204. The global power system 202 includes a first plurality of on-chip header devices H1, H2, ..., Hn for selectively providing a voltage VDDg to the plurality of voltage islands V1, V2, ..., Vn in response to first header control signals x1, x2, ..., xn, respectively. A global VDDg power supply 206 provides power to the header devices H1, H2, ..., Hn via a VDDg power distribution grid/bus 208. The quiescent power system 204 includes a second plurality of on-chip header devices H1q, H2q, ..., Hnq for selectively providing a quiescent voltage VDDq to the plurality of voltage islands V1, V2, ..., Vn in response to second header control signals x1q, x2q, ..., xnq, respectively, and a third plurality of on-chip header devices H1'q, H2'q, ..., Hn'q for selectively providing the quiescent voltage VDDq to the plurality of voltage islands V1, V2, ..., Vn in response to third header control signals x1'q, x2'q, ..., xn'q, respectively. A quiescent VDDq power supply 210 provides power to the header devices H1q, H2q, ..., Hnq via a VDDq power distribution grid/bus 212. The quiescent power system 204 also includes a plurality of voltage sensors 214, each located on a connection between the plurality of voltage islands V1, V2, ..., Vn and the header devices H1q, H2q, ..., Hnq and H1'q, H2'q, ..., Hn'q.

Locating the voltage sensors 214 on-chip provides many advantages over off-chip voltage measurements (e.g., at the tester). For example, voltage measurements can be made more quickly when the voltage sensors 214 are located on-chip. In addition, voltage measurements may be made in parallel on the plurality of voltage sensors 214 rather than one at a time, as would be the case where voltage measurements are made at the tester. Testing granularity can also be adjusted, based on the number/density of voltage sensors 214 that are used. For example, a greater number of voltage sensors 214 may be located in areas of a chip that are more susceptible to IDDQ defects, while a lesser number of voltage sensors 214 may be placed in other areas of the chip.

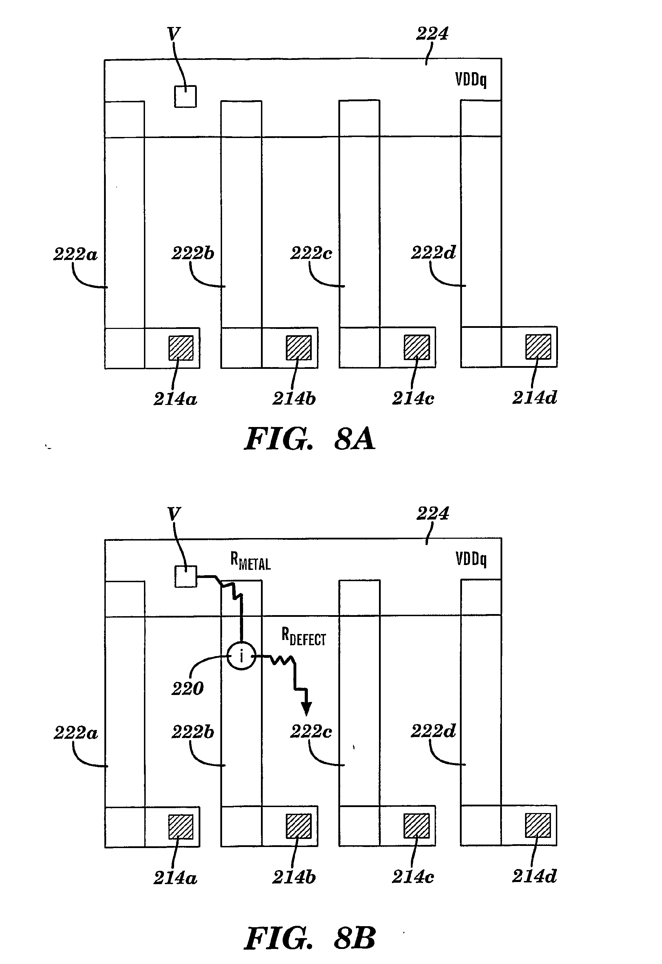

In FIG. 7, the plurality of voltage sensors 214 are shown located outside of the plurality of voltage islands V1, V2, ..., Vn. However, the plurality of voltage sensors 214 should be placed for optimal defect detection, which depends on how VDDq is implemented. For example, as shown in FIGS. 8A and 8B, an IDDq defect 220 may be detected by placing voltage sensors 214a, 214b, 214c, and 214d on VDDq conductive paths 222a, 222b, 222c, and 222d, respectively, (e.g., conductive paths to voltage islands or other circuits) and applying a test voltage V to the VDDq rail 224. When no IDDq defect exists as shown in FIG. 8A, then all of the voltage sensors 214a, 214b, 214c, and 214d see the voltage V applied to the VDDq rail 224 (ignoring background leakage). However, when an IDDq defect 220 exists, as shown in FIG. 8B, then voltage sensors 214a, 214c, and 214d see a voltage substantially equal to V, while voltage sensor 214b sees a voltage V_{214b} equal to Rₘₑₜₐₗ/R_{defect} * V, where Rₘₑₜₐₗ is the resistance of the metal forming the conductive path 222b and R_{defect} is the resistance of the IDDQ defect 220. Thus, in this case, the voltage sensors 222a, 222c, and 222d see a voltage of approximately V, while the voltage sensor 22b sees a voltage less than V (depending on the ratio of Rₘₑₜₐₗ/R_{defect}).

The foregoing description of various aspects of the invention has been presented for purposes of illustration and description. It is not intended to be exhaustive or to limit the invention to the precise form disclosed, and obviously, many modifications and variations are possible. Such modifications and variations that may be apparent to a person skilled in the art are intended to be included within the scope of the invention as defined by the accompanying claims. For example, the present invention can be applied to ground GND instead of VDD. Such a system would include a global ground bus and a quiescent ground bus, wherein current measurements are taken on separate ground supplies.

The invention is useful for integrated circuit testing. More particularly, the present invention provides a voltage island system including a hot-switch able voltage bus for IDDQ current measurements.

## Claims

1. A hot-switchable voltage bus for IDDQ measurement, **characterised by** the bus comprising:
a global voltage bus (108);
a quiescent voltage bus (112), separate from the global voltage bus;
at least one voltage island (V1, V2, ..., Vn);
A connection (H1, H2, ..., Hn; H1q, H2q, ..., Hnq) between each voltage island and the global and quiescent voltage busses; and
a system (102, 104) for selecting at least one of the connections to connect each voltage island to at least one of the global and quiescent voltage busses during IDDQ testing.

2. The bus of claim 1, wherein the system for selectively connecting is configured to switch each voltage island between the quiescent and global voltage busses.

3. The bus of claim 2, wherein each voltage island does not lose state during the switching between the quiescent and global voltage busses.

4. The bus of claim 2, further comprising a global power supply (106) for supplying a voltage VDDg to the global voltage bus and a quiescent power supply (110) for supplying a voltage VDDq to the quiescent voltage bus.

5. The bus of claim 4, wherein VDDg is equal to VDDq.

6. The bus of claim 5, wherein the IDDQ measurement is performed independently for VDDg and VDDq.

7. The bus of claim 1, wherein the system for selectively connecting comprises a header device (H1, H2, ..., Hn; H1q, H2q, ..., Hnq) for selectively connecting each voltage island to the quiescent and global voltage busses in response to a control signal.

8. The bus of claim 1, further comprising a plurality of voltage sensors (214).

9. A method for IDDQ testing, **characterised by** the method comprising:
hot-switching at least one voltage island (V1, V2, ..., Vn) between a global voltage bus (108) and a quiescent voltage bus (112) the switching comprising:
providing a connection (H1, H2, ..., Hn; H1q, H2q, ..., Hnq) between each voltage island and the global and quiescent voltage busses, and
selecting at least one of the connections to connect each voltage island to at least one of the global and quiescent voltage busses, and
performing IDDQ testing on the at least one voltage island.

10. The method of claim 9, wherein performing IDDQ testing comprises:
applying a test pattern (120) to each voltage island, wherein the test pattern remains valid during switching between the global and quiescent voltage busses.

11. The method of claim 9, further comprising:
locating IDDQ defects using a resistance of the quiescent voltage bus.

12. The method of claim 9, wherein IDDQ testing is performed on individual voltage islands or sets of voltage islands.

13. The method of claim 9, further comprising:
obtaining IDDQ measurements from individual voltage islands or sets of voltage islands during the IDDQ testing; and
comparing the obtained IDDQ measurements to other IDDQ measurements.

14. The method of claim 14, wherein the obtained IDDQ measurements are compared to IDDQ measurements for similar circuitry, or wherein the obtained IDDQ measurements are compared to an average IDDQ measurement.

## Patentansprüche

1. Während des laufenden Betriebs umschaltbarer Spannungsbus für die Ruhestrom-Messung (IDDQ measurement), **dadurch gekennzeichnet, dass** der Bus Folgendes umfasst:
einen globalen Spannungsbus (108);
einen Ruhespannungsbus (112), der von dem globalen Spannungsbus getrennt ist;
mindestens eine Spannungsinsel (V1, V2, ..., Vn);
eine Verbindung (H1, H2, ..., Hn; H1q, H2q, ..., Hnq) zwischen jeder Spannungsinsel und dem globalen sowie dem Ruhespannungsbus; und
ein System (102, 104) für das Auswählen von mindestens einer der Verbindungen, um jede Spannungsinsel während des IDDQ-Prüfens mit mindestens dem globalen und/oder dem Ruhespannungsbus zu verbinden.

2. Bus nach Anspruch 1, wobei das System für das selektive Verbinden so konfiguriert ist, dass jede Spannungsinsel zwischen dem Ruhe- und dem globalen Spannungsbus umgeschaltet wird.

3. Bus nach Anspruch 2, wobei jede Spannungsinsel während des Umschaltens zwischen dem Ruhe- und dem globalen Spannungsbus den Zustand unverändert beibehält.

4. Bus nach Anspruch 2, der weiter eine globale Spannungsversorgung (106) umfasst, um eine Spannung VDDg an den globalen Spannungsbus anzulegen, sowie eine Ruhespannungsversorgung (110) umfasst, um eine Spannung VDDq an den Ruhespannungsbus anzulegen.

5. Bus nach Anspruch 4, wobei VDDg gleich VDDq ist.

6. Bus nach Anspruch 5, wobei die IDDQ-Messung für VDDg und VDDq unabhängig durchgeführt wird.

7. Bus nach Anspruch 1, wobei das System für das selektive Verbinden eine Kopfeinheit (H1, H2, ..., Hn; H1q, H2q, ..., Hnq) umfasst, um als Reaktion auf ein Steuersignal jede Spannungsinsel selektiv mit dem Ruhe- bzw. dem globalen Spannungsbus zu verbinden.

8. Bus nach Anspruch 1, der weiter eine Vielzahl von Spannungssensoren (214) umfasst.

9. Verfahren für das IDDQ-Messen, **dadurch gekennzeichnet, dass** das Verfahren Folgendes umfasst:
während des laufenden Betriebs Umschalten von mindestens einer Spannungsinsel (V1, V2, ..., Vn) zwischen einem globalen Spannungsbus (108) und einem Ruhespannungsbus (112), wobei das Umschalten Folgendes umfasst:
Herstellen einer Verbindung (H1, H2, ..., Hn; H1q, H2q, ..., Hnq) zwischen jeder Spannungsinsel und dem globalen und dem Ruhespannungsbus, und
Auswählen von mindestens einer der Verbindungen, um jede Spannungsinsel mit mindestens dem globalen und/oder dem Ruhespannungsbus zu verbinden, und
Durchführen des IDDQ-Prüfens für die mindestens eine Spannungsinsel.

10. Verfahren nach Anspruch 9, wobei das Durchführen des IDDQ-Prüfens Folgendes umfasst:
Anlegen eines Prüfmusters (120) an jede Spannungsinsel, wobei das Prüfmuster während des Umschaltens zwischen dem globalen und dem Ruhespannungsbus gültig bleibt.

11. Verfahren nach Anspruch 9, das weiter Folgendes umfasst:
Auffinden von IDDQ-Fehlern unter Verwendung eines Widerstands des Ruhespannungsbusses.

12. Verfahren nach Anspruch 9, wobei das IDDQ-Prüfen für einzelne Spannungsinseln oder Gruppen von Spannungsinseln durchgeführt wird.

13. Verfahren nach Anspruch 9, das weiter Folgendes umfasst:
Erhalten von IDDQ-Messwerten von einzelnen Spannungsinseln oder Gruppen von Spannungsinseln während des IDDQ-Prüfens; und
Vergleichen der erhaltenen IDDQ-Messwerte mit anderen IDDQ-Messwerten.

14. Verfahren nach Anspruch 14, wobei die erhaltenen IDDQ-Messwerte mit IDDQ-Messwerten für ähnliche Schaltkreise verglichen werden oder wobei die erhaltenen IDDQ-Messwerte mit einem durchschnittlichen IDDQ-Messwert verglichen werden.

## Revendications

1. Bus de tension commutable à chaud pour une mesure IDDQ, **caractérisé par le fait que** le bus comprenne :
un bus de tension globale (108),
un bus de tension de repos (112), différent du bus de tension globale,
au moins un îlot de tension (V1, V2, ..., Vn),
une connexion (H1, H2, ..., Hn; H1q, H2q, ..., Hnq) entre chaque îlot de tension et les bus de tension globale et de repos, et
un système (102, 104) destiné à sélectionner au moins l'une des connexions pour connecter chaque îlot de tension à au moins l'un des bus de tension globale et de repos au cours d'un essai IDDQ.

2. Bus selon la revendication 1, dans lequel le système de connexion sélective est configuré pour commuter chaque îlot de tension entre les bus de tension de repos et global.

3. Bus selon la revendication 2, dans lequel chaque îlot de tension ne perd pas d'état au cours de la commutation entre les bus de tension de repos et global.

4. Bus selon la revendication 2, comprenant en outre une alimentation électrique globale (106) destinée à fournir une tension VDDg au bus de tension globale et une alimentation électrique de repos (110) destinée à fournir une tension VDDq au bus de tension de repos.

5. Bus selon la revendication 4, dans lequel la tension VDDg est égale à la tension VDDq.

6. Bus selon la revendication 5, dans lequel la mesure IDDQ est effectuée indépendamment de VDDg et de VDDq.

7. Bus selon la revendication 1, dans lequel le système de connexion sélective comprend un dispositif de branchement (H1, H2, ..., Hn ; H1q, H2q, ..., Hnq) destiné à connecter sélectivement chaque îlot de tension aux bus de tension de repos et global en réponse à un signal de commande.

8. Bus selon la revendication 1, comprenant en outre une pluralité de capteurs de tension (214).

9. Procédé d'essai IDDQ, **caractérisé par le fait que** le procédé comprenne les étapes consistant à :
commuter à chaud au moins un îlot de tension (V1, V2, ..., Vn) entre un bus de tension globale (108) et un bus de tension de repos (112), la commutation comprenant les étapes consistant à :
fournir une connexion (H1, H2, ..., Hn ; H1q, H2q, ..., Hnq) entre chaque îlot de tension et les bus de tension globale et de repos, et
sélectionner au moins l'une des connexions pour connecter chaque îlot de tension à au moins l'un des bus de tension globale et de repos, et
effectuer un essai IDDQ sur au moins un îlot de tension.

10. Procédé selon la revendication 9, dans lequel la réalisation d'un essai IDDQ comprend l'étape consistant à :
appliquer une configuration d'essai (120) à chaque îlot de tension, où la configuration d'essai reste valide au cours de la commutation entre les bus de tension globale et de repos.

11. Procédé selon la revendication 9, comprenant en outre l'étape consistant à :
localiser des défauts IDDQ en utilisant une résistance du bus de tension de repos.

12. Procédé selon la revendication 9, dans lequel l'essai IDDQ est effectué sur des îlots de tension individuels ou des ensembles d'îlots de tension.

13. Procédé selon la revendication 9, comprenant en outre les étapes consistant à :
obtenir des mesures IDDQ à partir d'îlots de tension individuels ou d'ensembles d'îlots de tension au cours de l'essai IDDQ, et
comparer les mesures IDDQ obtenues à d'autres mesures IDDQ.

14. Procédé selon la revendication 14, dans lequel les mesures IDDQ obtenues sont comparées à des mesures IDDQ pour des circuits similaires, ou dans lequel les mesures IDDQ obtenues sont comparées à une mesure IDDQ moyenne.
